# EUROPEAN PATENT APPLICATION

(11) **EP 4 425 780 A1**
(43) Date of publication of application: **04.09.2024**
(21) Application number: 23159870.7
(22) Date of filing: 03.03.2023
(51) Int. Cl.: H02M 7/00, H02M 7/487, H01L 25/07, H02M 1/00

(54) **SEMICONDUCTOR ARRANGEMENT AND SEMICONDUCTOR MODULE ARRANGEMENT**

(71) Applicant: Infineon Technologies AG, 85579 Neubiberg (DE)
(72) Inventor: POLLER, Tilo, 59494 Soest (DE); MÜLLER, Christian, 97424 Schweinfurt (DE)
(74) Representative: Westphal, Mussgnug & Partner, Patentanwälte mbB

(57) **Abstract**

A semiconductor arrangement includes a first supply node (P1) configured to be operatively connected to a first electrical potential (DC+), and a second supply node (N1) configured to be operatively connected to a second electrical potential (DC-), the first electrical potential (DC+) being positive with reference to the second electrical potential (DC-), a first controllable semiconductor element (T1) and a second controllable semiconductor element (T2), each having a control electrode (G1, G2) and a controllable load path between two load electrodes, the load paths being operatively connected in series and between the first supply node (P1) and the second supply node (N1), the first controllable semiconductor element (T1) and the second semiconductor element (T2) being connected with each other via an output node (AC1), a first and a second freewheeling element (D 1, D2), each having a first electrode and a second electrode, the first freewheeling element (D1) being connected in parallel to the first controllable semiconductor element (T1) and between the respective nodes, and the second freewheeling element (D2) being connected in parallel to the second controllable semiconductor elements (T2) and between the respective nodes, a third freewheeling element (D3) having a first electrode and a second electrode, and a fourth controllable semiconductor element (T4) having a control electrode (G4) and a controllable load path between two load electrodes, the third freewheeling element (D3) and the load path of the fourth controllable semiconductor element (T4) being operatively coupled in series and between the output node (AC1) and a first midpoint node (M1), and a third controllable semiconductor element (T3) having a control electrode (G3) and a controllable load path between two load electrodes, and a fourth freewheeling element (D4) having a first electrode and a second electrode, the load path of the third controllable semiconductor element (T3) and the fourth freewheeling element (D4) being operatively connected in series and between the output node (AC1) and a second midpoint node (M2) that is different from the first midpoint node.

## Description

### TECHNICAL FIELD

The instant disclosure relates to semiconductor arrangements and semiconductor module arrangements.

### BACKGROUND

Semiconductor arrangements, e.g., implemented in a semiconductor module arrangement, or the like, are widely used in automotive, industrial, and consumer electronic applications for driving loads, converting power, or the like. Such a semiconductor arrangement may include an NPC (Neutral-Point Clamped) topology (e.g., NPC2 topology), for example. An NPC topology includes several controllable semiconductor elements, each semiconductor element having a load path formed between a first load electrode (e.g., a source electrode or an emitter electrode) and a second load electrode (e.g., a drain electrode or a collector electrode), and a control electrode (e.g. a gate or base electrode). However, implementing an NPC topology in a semiconductor module often leads to poor switching characteristics, high stray inductances, and a non-satisfactory thermal performance.

Hence, there is a general need for a semiconductor arrangement with improved switching characteristics, low stray inductance, and an improved thermal performance.

### SUMMARY

A semiconductor arrangement includes a first supply node configured to be operatively connected to a first electrical potential, and a second supply node configured to be operatively connected to a second electrical potential, the first electrical potential being positive with reference to the second electrical potential, a first controllable semiconductor element and a second controllable semiconductor element, each having a control electrode and a controllable load path between two load electrodes, the load paths being operatively connected in series and between the first supply node and the second supply node, the first controllable semiconductor element and the second semiconductor element being connected with each other via an output node, a first and a second freewheeling element, each having a first electrode and a second electrode, the first freewheeling element being connected in parallel to the first controllable semiconductor element and between the respective nodes, and the second freewheeling element being connected in parallel to the second controllable semiconductor elements and between the respective nodes, a third freewheeling element having a first electrode and a second electrode, and a fourth controllable semiconductor element having a control electrode and a controllable load path between two load electrodes, the third freewheeling element and the load path of the fourth controllable semiconductor element being operatively coupled in series and between the output node and a first midpoint node, and a third controllable semiconductor element having a control electrode and a controllable load path between two load electrodes, and a fourth freewheeling element having a first electrode and a second electrode, the load path of the third controllable semiconductor element and the fourth freewheeling element being operatively connected in series and between the output node and a second midpoint node that is different from the first midpoint node.

For positive power factors cos ϕ, the first controllable semiconductor element, the first freewheeling element, the third freewheeling element, and the fourth controllable semiconductor element may form a first main commutation loop, and the second controllable semiconductor element, the second freewheeling element, the third controllable semiconductor element, and the fourth freewheeling element may form a second main commutation loop. For negative power factors cos ϕ, the first controllable semiconductor element, the first freewheeling element, the fourth freewheeling element, and the third controllable semiconductor element may form a third main commutation loop, and the second controllable semiconductor element, the second freewheeling element, the fourth controllable semiconductor element, and the third freewheeling element may form a fourth main commutation loop.

A semiconductor module arrangement includes a first substrate and a second substrate, and a plurality of semiconductor bodies forming the semiconductor arrangement. Either a plurality of semiconductors forming the first main commutation loop is arranged on the first substrate, and a plurality of semiconductor bodies forming the second main commutation loop is arranged on the second substrate, or a plurality of semiconductor bodies forming the third main commutation loop is arranged on the first substrate, and a plurality of semiconductor bodies forming the fourth main commutation loop is arranged on the second substrate.

The invention may be better understood with reference to the following drawings and the description. The components in the figures are not necessarily to scale, emphasis instead being placed upon illustrating the principles of the invention. In the figures, like referenced numerals designate corresponding parts throughout the different views.

### BRIEF DESCRIPTION OF THE DRAWINGS

Figure 1 is a circuit diagram of a semiconductor arrangement.
Figure 2 is a circuit diagram of a semiconductor arrangement according to embodiments of the disclosure.
Figure 3, including Figures 3A and 3B, schematically illustrates current flows within the main commutation loops of the circuit of Figure 2 for positive power factors cos ϕ, and a resulting output current over time.
Figure 4 schematically illustrates current flows within the main commutation loops of the circuit of Figure 2 for negative power factors cos cp.
Figure 5 schematically illustrates a power semiconductor module arrangement according to embodiments of the disclosure.
Figure 6 schematically illustrates a power semiconductor module arrangement according to further embodiments of the disclosure.
Figure 7, including Figures 7A and 7B, schematically illustrates current flows within power semiconductor module arrangements according to embodiments of the disclosure for positive power factors cos ϕ (Figure 7A) and for negative power factors cos ϕ (Figure 7B).
Figure 8 schematically illustrates a power semiconductor module arrangement according to further embodiments of the disclosure.
Figure 9 schematically illustrates a power semiconductor module arrangement according to even further embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. As well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or connection element as described herein may be a single electrically conductive element, or include at least two individual electrically conductive elements connected in series and/or parallel. Electrical lines or connection elements may include metal and/or semiconductor material, and may be permanently electrically conductive (i.e., non-switchable). An electrical line or connection element may have an electrical resistivity that is independent from the direction of a current flowing through it. A semiconductor body as described herein may be made of (doped) semiconductor material and may be a semiconductor chip or be included in a semiconductor chip. A semiconductor body has electrically connecting pads and includes at least one semiconductor element with electrodes. The pads are electrically connected to the electrodes which includes that the pads are the electrodes and vice versa.

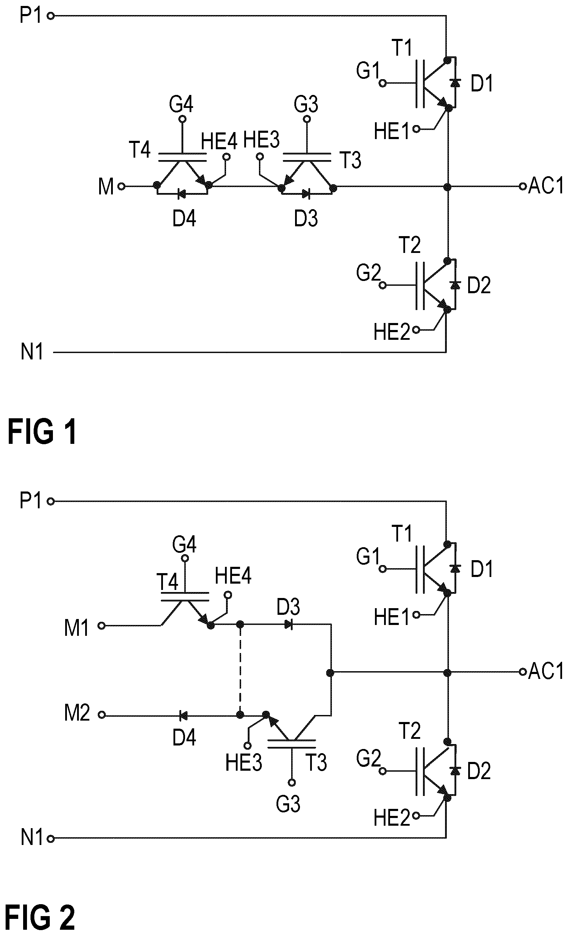

Referring to Figure 1, a semiconductor arrangement is schematically illustrated. The semiconductor arrangement of Figure 1 may include and may be operated in the way of an NPC (Neutral-Point Clamped) topology (i.e. a so-called NPC2 topology). In particular, Figure 1 is a circuit diagram of an exemplary three-level NPC2 topology. The semiconductor arrangement in Figure 1 includes a first supply node P1 which is configured to be operatively connected to a first electrical potential. The semiconductor arrangement further includes a second supply node N1 which is configured to be operatively connected to a second electrical potential. The first potential is positive with reference to the second potential. For example, the first potential may be a positive potential DC+ and the second potential may be a negative potential DC-. The arrangement further includes a first controllable semiconductor element T1 and a second controllable semiconductor element T2. Each of the first controllable semiconductor element T1 and the second controllable semiconductor element T2 includes a control electrode G1, G2 and a controllable load path between a first load electrode (e.g., collector or drain electrode) and a second load electrode (e.g., emitter or source electrode). The load paths of the first controllable semiconductor element T1 and the second controllable semiconductor element T2 are coupled in series and between the first supply node P1 and the second supply node N1. The first controllable semiconductor element T1 (i.e. the second load electrode of the first controllable semiconductor element T1) and the second controllable semiconductor element T2 (i.e. the first load electrode of the second controllable semiconductor element T2) are connected with each other via a first common node forming an output node AC1. The first load electrode of the first controllable semiconductor element T1 is connected to the first supply node P 1, and the second load electrode of the second controllable semiconductor element T2 is connected to the second supply node N1.

The arrangement further includes a third controllable semiconductor element T3 and a fourth controllable semiconductor element T4. Each of the third controllable semiconductor element T3 and the fourth controllable semiconductor element T4 includes a control electrode G3, G4 and a controllable load path between a first load electrode (e.g., collector or drain electrode) and a second load electrode (e.g., emitter or source electrode). The load paths of the third controllable semiconductor element T3 and the fourth controllable semiconductor element T4 are coupled in series and between the output node AC1 and a midpoint node M (often also referred to as neutral node). The third controllable semiconductor element T3 (i.e. the second load electrode of the third controllable semiconductor element T3) and the fourth controllable semiconductor element T4 (i.e. the second load electrode of the fourth controllable semiconductor element T4) are connected with each other via a second common node, wherein the third controllable semiconductor element T3 is arranged between the second common node and the output node AC1, and the fourth controllable semiconductor element T4 is arranged between the second common node and the midpoint node M.

Each of the controllable semiconductor elements T1, T2, T3, T4 may be implemented by means of a single component or by means of a plurality of identical controllable semiconductor subcomponents, each subcomponent having a control electrode and a controllable load path between a first load electrode and a second load electrode, the load paths being operatively connected in parallel between the nodes between which the respective controllable semiconductor element is connected.

Each of the controllable semiconductor elements T1, T2, T3, T4 may include an intrinsic freewheeling element such as a body diode, which is electrically connected between the first load electrode and the second load electrode of the respective controllable semiconductor element T1, T2, T3, T4 (intrinsic freewheeling elements not specifically illustrated in Figure 1). The semiconductor arrangement further includes first, second, third and fourth freewheeling elements D1, D2, D3, D4. Each of the first, second, third, and fourth freewheeling elements D1, D2, D3, D4 includes a first electrode (e.g., anode) and a second electrode (e.g., cathode). Each of the first, second, third and fourth freewheeling elements D1, D2, D3, D4 may be connected in parallel to one of the controllable semiconductor elements T1, T2, T3, T4. For example, the first freewheeling element D1 may be connected to the first supply node P1 with its second electrode and to the first common node (output node AC1) with its first electrode such that it is connected between the first supply node P1 and the output node AC1 and in parallel to the load path of the first controllable semiconductor element T1. The second freewheeling element D2 may be connected to the output node AC1 with its second electrode and to the second supply node N1 with its first electrode such that it is connected between the output node AC1 and the second supply node N1 and in parallel to the load path of the second controllable semiconductor element T2. The third freewheeling element D3 may be connected to the output node AC1 with its second electrode and to the second common node with its first electrode such that it is connected between the output node AC1 and the second common node and in parallel to the load path of the third controllable semiconductor element T3. The fourth freewheeling element D4 may be connected to the midpoint node M with its second electrode and to the second common node with its first electrode such that it is connected between the midpoint node M and the second common node and in parallel to the load path of the fourth controllable semiconductor element T4. Each of the controllable semiconductor elements T1, T2, T3, T4 may further be connected to a respective auxiliary emitter node HE1, HE2, HE3, HE4. In particular, the second load electrode of each controllable semiconductor element T1, T2, T3, T4 may be connected to a respective auxiliary emitter node HE1, HE2, HE3, HE4. The auxiliary emitter nodes HE1, HE2, HE3, HE4, however, are optional and may be omitted.

Each of the controllable semiconductor elements T1, T2, T3, T4 may include a semiconductor switch. The individual semiconductor switches may include a transistor such as a MOSFET (Metal Oxide Semiconductor Field-Effect Transistor), IGBT (Insulated Gate Bipolar Transistor), JFET (Junction Field Effect Transistor), HEMT (High Electron Mobility Transistor), BIP (Bipolar Transistor), or any other kind of transistor, for example.

The semiconductor arrangement as illustrated in Figure 1 is configured to convert a DC voltage provided at an input P1, N1 into an AC voltage provided at the output node AC1. The AC voltage may be provided to, e.g., a load (not illustrated) that is coupled to the output node AC1 of the semiconductor arrangement. The load may be an inductive load, for example.

When a semiconductor arrangement is implemented in a semiconductor module arrangement, usually a great number of semiconductor components

(semiconductor bodies) is required, wherein the semiconductor bodies are arranged on one or more substrates of the semiconductor module arrangement. When arranging a great number of semiconductor bodies on one or more substrates of a semiconductor module arrangement, this may result in highly complex commutation paths, poor switching characteristics, high stray inductances, and a non-satisfactory thermal performance of the semiconductor module arrangement.

Now referring to Figure 2, a semiconductor arrangement according to embodiments of the disclosure is schematically illustrated. In order to avoid the problems mentioned above, the semiconductor arrangement, instead of a single midpoint node M, comprises a first midpoint node M1 and a second midpoint node M2 which is separate and distinct from the first midpoint node M1. The first controllable semiconductor element T1, the second controllable semiconductor element T2, the first freewheeling element D1 and the second freewheeling element D2 are arranged similar to what has been described with respect to Figure 1 above.

The fourth controllable semiconductor element T4 and the third freewheeling element D3, however, are coupled in series and between the output node AC1 and the first midpoint node M1. The fourth controllable semiconductor element T4 (i.e. the second load electrode of the fourth controllable semiconductor element T4) and the third freewheeling element D3 (i.e. the first electrode of the third freewheeling element D3) are connected with each other via a third common node. The fourth controllable semiconductor element T4 is connected to the first midpoint node M1 with its first load electrode, and the third freewheeling element D3 is connected to the output node AC1 with its second electrode.

The third controllable semiconductor element T3 and the fourth freewheeling element D4 are coupled in series and between the output node AC1 and the second midpoint node M2. The third controllable semiconductor element T3 (i.e. the second load electrode of the third controllable semiconductor element T3) and the fourth freewheeling element D4 (i.e. the first electrode of the fourth freewheeling element D4) are connected with each other via a fourth common node. The third controllable semiconductor element T3 is connected to the output node AC1 with its first load electrode, and the fourth freewheeling element D4 is connected to the second midpoint node M2 with its second electrode. The third common node and the fourth common node may be separate and distinct from each other or may correspond to each other. This will be described in further detail below.

The arrangement schematically illustrated in Figure 2 can be referred to as a "common emitter" arrangement. Alternatively, it is however also possible that the first load electrode of the fourth controllable semiconductor element T4 and the second electrode of the third freewheeling element D3 are connected with each other via the third common node, and that the fourth controllable semiconductor element T4 is connected to the first midpoint node M1 with its second load electrode, and the third freewheeling element D3 is connected to the output node AC1 with its first electrode. Likewise, the first load electrode of the third controllable semiconductor element T3 and the second electrode of the fourth freewheeling element D4 may then be connected with each other via the fourth common node such that the third controllable semiconductor element T3 is connected to the output node AC1 with its second load electrode, and the fourth freewheeling element D4 is connected to the second midpoint node M2 with its first electrode. Such an arrangement may also be referred to as "common collector" arrangement. The principles described herein apply equally for "common emitter" and "common collector" arrangements.

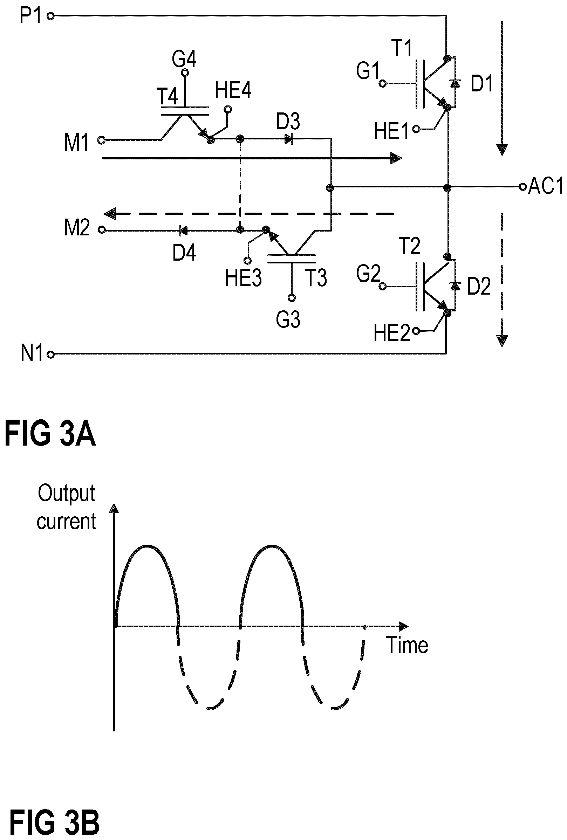

Now referring to Figure 3A, the main commutation loops within the semiconductor arrangement of Figure 2 are schematically illustrated for power factors cos ϕ of between 0 and 1 (positive power factor, cos ϕ = 0.... 1). A first main commutation loop is indicated by means of the solid arrows, and a second main commutation loop is indicated by means of the dashed arrows, wherein the arrows indicate a current flow within the respective main commutation loop. That is, the first controllable semiconductor element T1 and the third freewheeling element D3 may be active at the same time while, e.g., the second controllable semiconductor element T2 and the fourth freewheeling element D4 are inactive. Similarly, the second controllable semiconductor element T2 and the fourth freewheeling element D4 may be active while, e.g., the first controllable semiconductor element T1 and the third freewheeling element D3 are inactive. This results in the output current (or active power for positive power factor, cos ϕ) as indicated in Figure 3B, wherein the solid lines indicate the output current when the first main commutation loop is active, and the dashed lines indicate the output current when the second commutation loop is active.

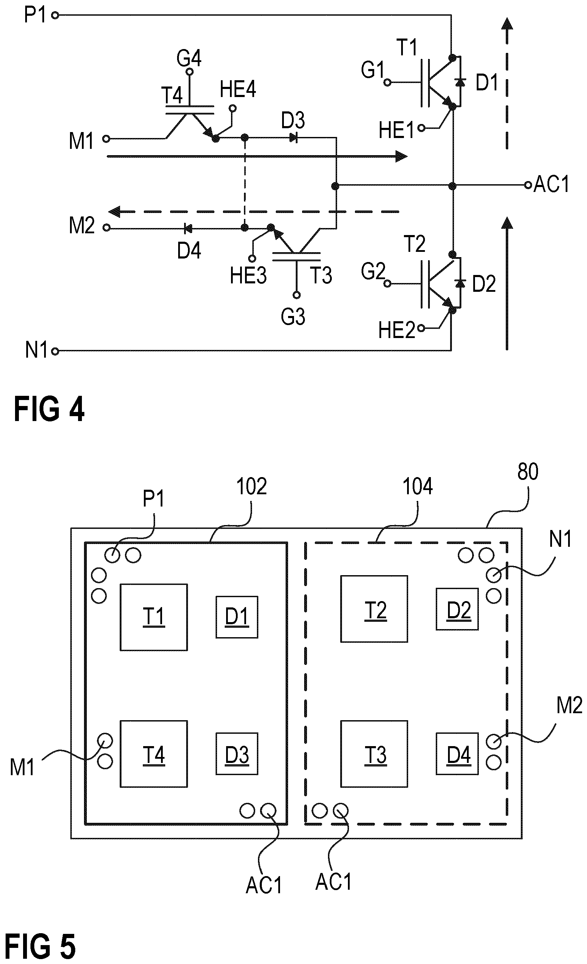

Now referring to Figure 4, the main commutation loops within the semiconductor arrangement of Figure 2 are schematically illustrated for power factors cos ϕ of between -1 and 0 (negative power factor, cos ϕ = -1.... 0). A third main commutation loop is indicated by means of the solid arrows, and a fourth main commutation loop is indicated by means of the dashed arrows in Figure 4, wherein the arrows indicate a current flow within the respective main commutation loop. That is, the fourth controllable semiconductor element T4 and the second freewheeling element D2 may be active at the same time while, e.g., the third controllable semiconductor element T3 and the first freewheeling element D1 are inactive. Similarly, the third controllable semiconductor element T3 and the first freewheeling element D1 may be active at the same time while, e.g., the fourth controllable semiconductor element T4 and the second freewheeling element D2 are inactive. The resulting output current (or reactive power for negative power factor, cos ϕ) is the same as illustrated in Figure 3B.

Negative power factors may arise in a failure mode, while positive power factors are generally targeted in applications as a main operation mode (e.g., in solar applications). Therefore, for certain load cases, semiconductor arrangements may have to cover negative power factors as well. An example for such a load case may be a grid failure such as, e.g., a low voltage ride through. The main commutation loops as illustrated in Figure 4, however, usually have high stray inductances.

Now referring to Figure 5, the semiconductor arrangement of Figure 2 can be implemented in a single power semiconductor module arrangement 80. The power semiconductor module arrangement 80 comprises two separate substrates 102, 104. Those elements that are active at the same time are arranged together on one of the substrates 102, 104. As the main operation mode generally targets positive power factors, any elements included in the first main commutation loop (e.g., first controllable semiconductor element T1, first freewheeling element D1, fourth controllable semiconductor element T4, third freewheeling element D3) may be arranged on a first substrate 102, while any elements included in the second main commutation loop (e.g., second controllable semiconductor element T2, second freewheeling element D2, third controllable semiconductor element T3, fourth freewheeling element D4) may be arranged on a second substrate 104. The arrangement of the elements in Figure 5 is illustrated only very schematically. Generally, a substrate comprises a dielectric insulation layer and a metallization layer arranged on the dielectric insulation layer. The metallization layer usually is a structured layer. That is, the metallization layer comprises recesses between different separate sections of the metallization layer. Different sections may be coupled to different potentials. Different semiconductor elements (semiconductor bodies) may be arranged on different sections of the metallization layer. Electrical connections between semiconductor elements and further sections of the first metallization layer may further be implemented by means of electrical connection elements such as, e.g., bonding wires or bonding ribbons. Different sections of the metallization layer as well as electrical connections, however, are not specifically illustrated in Figure 5, as this is not required for understanding the general principle of the present disclosure.

Figure 5 further illustrates very generally different terminals arranged on the respective substrates 102, 104 that form or are connected to the respective nodes as illustrated in Figure 3A. That is, terminals forming or connected to the first supply node P1, terminals forming or connected to the output node AC1, and terminals forming or connected to the first midpoint node M1 are arranged on the first substrate 102, while terminals forming or connected to the second supply node N1, terminals forming or connected to the output node AC1, and terminals forming or connected to the second midpoint node M2 are arranged on the second substrate 104. In this way, the main commutation loops are essentially separated. Terminals that form or are coupled to different nodes and potentials are generally arranged on different sections of the metallization layer. Such details, however, are omitted in Figure 5 for the sake of simplicity.

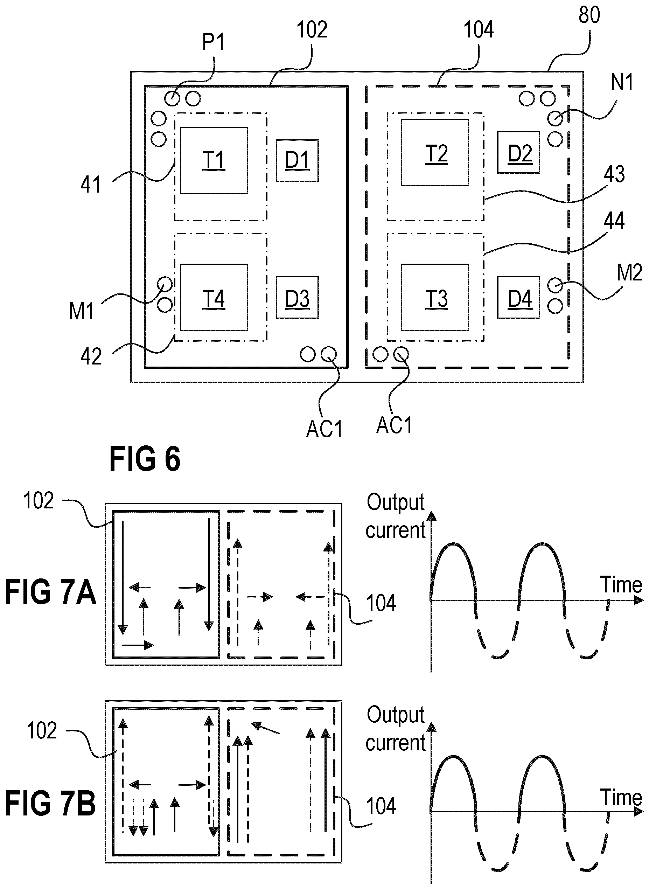

Exemplary current flows in the semiconductor module arrangement of Figure 5 are illustrated in Figure 7, wherein Figure 7A illustrates exemplary current flows for positive power factors cos ϕ, and Figure 7B illustrates exemplary current flows for negative power factors cos ϕ. As can be seen, for positive power factors cos ϕ the current flows are completely separated. That is, while the first main commutation loop is active, currents will flow solely on the first substrate 102 (indicated by solid arrows), and while the second main commutation loop is active, currents will flow solely on the second substrate 104 (indicated by dashed arrows). Only during failure mode (negative power factors ϕ), currents may flow on both substrates 102, 104 at the same time.

By arranging those elements that are active at the same time on the same substrate, an improved switching characteristic, low stray inductances, and an improved thermal performance may be achieved for the power semiconductor module arrangement 80. At least the thermal performance may be improved even further by arranging the different elements in several groups. For example, any fast switching elements (e.g., one or more semiconductor bodies forming the first controllable semiconductor element T1) arranged on the first substrate 102 may be arranged together as a first group of elements 41 in a first section of the first substrate 102, and any slow switching elements (e.g., one or more semiconductor bodies forming the fourth controllable semiconductor element T4) arranged on the first substrate 102 may be arranged together as a second group of elements 42 in a second section of the first substrate 102. Grouping fast switching elements and slow switching elements in different sections of the substrate 102 may further result in improved current sharing. The same applies for the second substrate 104. That is, any fast switching elements (e.g., one or more semiconductor bodies forming the second controllable semiconductor element T2) arranged on the second substrate 104 may be arranged together as a third group of elements 43 in a first section of the second substrate 104, and any slow switching elements (e.g., one or more semiconductor bodies forming the third controllable semiconductor element T3) arranged on the second substrate 104 may be arranged together as a fourth group of elements 44 in a second section of the second substrate 104. This is schematically illustrated in Figure 6.

In many applications, fast switching transistors and diodes, such as SiC or GaN transistors and diodes, for example, are used to implement switches to allow for a fast switching of the semiconductor arrangement. However, fast switching semiconductor elements are usually comparatively expensive. Therefore, implementing each individual switch (semiconductor element) of a semiconductor arrangement as a fast switching element may be very costly. Some semiconductor elements (switches) are therefore usually implemented as slow switching devices. By implementing at least some of the switching elements as slow switching elements, the overall cost of a semiconductor module arrangement may be reduced.

A fast switching element generally is a switching element that may perform a switching operation (e.g., from the on-state to an off-state or vice versa) at a certain speed. A threshold speed may be defined in this regard. If a switching element switches faster than the threshold speed, it may be defined as fast switching element. If a switching element switches slower than the threshold speed, it may be defined as slow switching element. For example, a switching element having a turn-on time of <100ns (nanoseconds) and a turn-off time of < 100ns, may be seen as a fast switching device, and a switching element having a turn-on time of≥100ns (nanoseconds) and a turn-off time of ≥100ns, may be seen as a slow switching device.

When arranging a first subset of the components of the semiconductor arrangement of Figure 2 on a first substrate 102, and arranging a second subset of the components of the semiconductor arrangement on a second substrate 104, the components may be arranged on the different substrates 102, 104 in a similar way. According to one example, the components on the first substrate 102 may be arranged symmetrically to the components on the second substrate 104. An exact symmetry, however, is not necessarily required. The arrangement of the components on the different substrate 102, 104, however, may result in an essentially similar performance for the two subsystems (for positive and negative sine half-wave of the output current). The layouts on the separate substrates 102, 104 may result in an essentially symmetric electrical performance of the two subsystems. That is, the current flows on the separate substrates 102, 104 may be very similar, but not necessarily exactly symmetric.

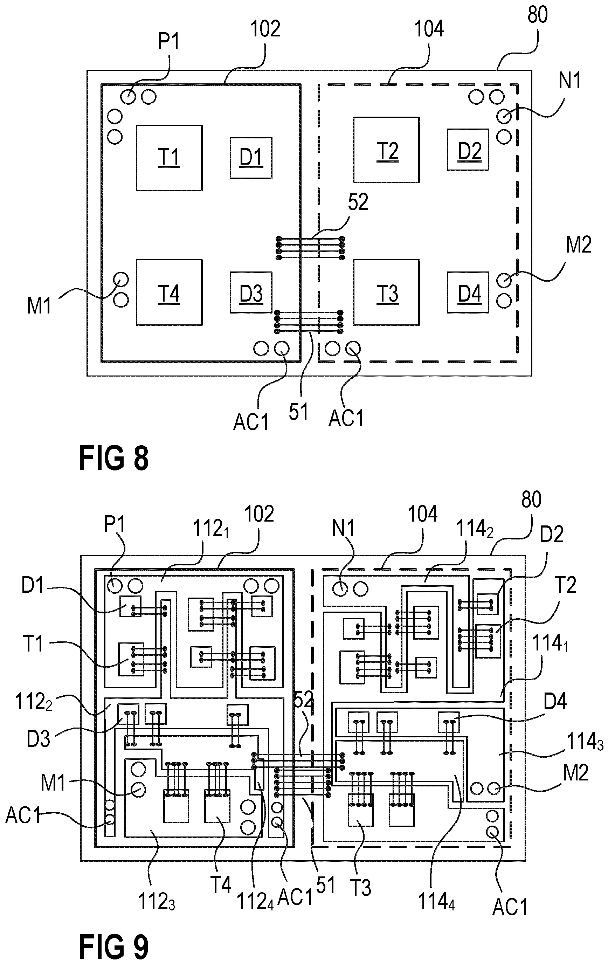

For negative power factors cos ϕ, commutation between the two substrates 102, 104 occurs, as has been schematically illustrated in Figure 7B, for example. For this reason, electrical connections may be provided between the two separate substrates 102, 104. This is very schematically illustrated in Figure 8. According to one example, a first electrical connection 51 may be provided between the output potential AC1 on the first substrate 102 and the output potential AC1 on the second substrate 104. The first electrical connection 51 may include one or more electrical connection elements such as, e.g., bonding wires, bonding ribbons, or connection rails, for example. A second electrical connection 52 may be provided between an auxiliary potential on the first substrate 102 and an auxiliary potential on the second substrate 104. For example, an auxiliary emitter HE4 of the fourth controllable semiconductor element T4 arranged on the first substrate 102, and an auxiliary emitter HE3 of the third controllable semiconductor element T3 on the second substrate 104 may be electrically coupled by means of the second electrical connection 52. The second electrical connection 52 may include one or more electrical connection elements such as, e.g., bonding wires, bonding ribbons, or connection rails, for example.

The first midpoint node M1 on the first substrate 102, and the second midpoint node M2 on the second substrate 104 may be separated from each other on the different substrates 102, 104. That is, no electrical connection may be provided to electrically couple the first and second midpoint nodes M1, M2 to each other. During forward recovery of the third freewheeling element D3, the fourth controllable semiconductor element T4 is generally sufficiently protected against reverse currents. The same applies for the third controllable semiconductor element T3, during forward recovery of the fourth freewheeling element D4. As the third and fourth controllable semiconductor elements T3, T4 are sufficiently protected against reverse currents, electrically connecting the first midpoint node M1 and the second midpoint node M2 to each other is generally not required.

It is, however, possible to optionally electrically couple the third common node to the fourth common node, as is schematically illustrated in Figures 2, 3A and 4, for example, by means of a dashed line. Interconnecting the third common node and the fourth common node may provide additional protection of the elements of the semiconductor arrangement.

Alternatively, it is also possible to implement the third and fourth controllable semiconductor elements T3, T4 as semiconductor devices that are able to conduct a current in reverse direction. Such semiconductor devices include, e.g., RC-IGBTs or MOSFETS. As the third and fourth freewheeling elements D3, D4 take over a DC-link voltage during reverse recovery, there is no need for implementing a commutation robustness, for example. As the first and second midpoint nodes M1, M2 do not need to be connected to each other, there is free space on the substrates 102, 104 which may be used to implement interconnections between the output nodes AC1 on the different substrates 102, 104, for example. Establishing a low-inductive connection between the output node AC1 on the first substrate 102, and the output node AC1 on the second substrate 104 allows a sound operation of the semiconductor arrangement also during failure mode (negative power factors cos ϕ).

Summarizing the above, the elements of the semiconductor arrangement of Figure 2 are separated into two different subgroups. Each subgroup is arranged on a different one of two substrates 102, 104 and comprises the elements that are included in a respective one of the main commutation loops of the semiconductor arrangement for positive power factors cos ϕ. That is, during normal operation of the semiconductor arrangement, the elements arranged on the first substrate 102 are active at the same time, resulting in currents flowing on the first substrate 102 while no current is flowing on the second substrate 104, and the elements arranged on the second substrate 104 are active at the same time, resulting in currents flowing on the second substrate 104 while no current is flowing on the first substrate 102. The separation of the current flows on separate substrates 102, 104 is achieved by providing two separate midpoint nodes M1, M2 that are not directly connected to each other. During failure mode (negative power factors cos ϕ), currents may flow on both substrates 102, 104 at the same time. For this reason, certain electrical connections may be provided between the different substrates 102, 104.

Alternatively, it is however also possible to arrange the first controllable semiconductor element T1, the first freewheeling element D1, the third controllable semiconductor element T3, and the fourth freewheeling element D4 on the first substrate 102, and the second controllable semiconductor element T2, the second freewheeling element D2, the fourth controllable semiconductor element T4, and the third freewheeling element D3 on the second substrate 104 (not specifically illustrated in the figures). In this case, during what may be referred to as failure mode of the semiconductor arrangement (negative power factors cos ϕ), the elements arranged on the first substrate 102 are active at the same time, resulting in currents flowing on the first substrate 102 while no current is flowing on the second substrate 104, and the elements arranged on the second substrate 104 are active at the same time, resulting in currents flowing on the second substrate 104 while no current is flowing on the first substrate 102. During normal operation (positive power factors cos ϕ), currents may then flow on both substrates 102, 104 at the same time. For some applications, the mode referred to as failure mode herein may be considered normal operation mode instead and vice versa. The principles that have been discussed above similar apply for such an alternative arrangement.

Now referring to Figure 9, a power semiconductor module arrangement 80 according to embodiments of the disclosure is schematically illustrated. Figure 9 schematically illustrates a top view of a power semiconductor module arrangement 80 comprising a first substrate 102 and a second substrate 104. A metallization layer comprising a plurality of different sections 112₁, 112₂, 112₃, 112₄ is arranged on a dielectric insulation layer of the first substrate 102, and a metallization layer comprising a plurality of different sections 114₁, 114₂, 114₃, 114₄ is arranged on a dielectric insulation layer of the second substrate 104.

A first section 112i of the metallization layer of the first substrate 102 may be electrically coupled to the first supply node P1. One or more semiconductor bodies forming the first controllable semiconductor element T1 as well as one or more semiconductor bodies forming the first freewheeling element D1 are arranged on the first section 112i of the metallization layer of the first substrate 102. Each of the one or more semiconductor bodies forming the first controllable semiconductor element T1 and each of the one or more semiconductor bodies forming the first freewheeling element D1 may be electrically coupled to the first section 112i of the metallization layer of the first substrate 102 by means of an electrically conducting connection layer. Each of the one or more semiconductor bodies forming the first controllable semiconductor element T1 and each of the one or more semiconductor bodies forming the first freewheeling element D1 may be electrically coupled to a second section 112₂ of the metallization layer of the first substrate 102 by means of one or more electrical connections (e.g., bonding wires or ribbons). The second section 112₂ of the metallization layer of the first substrate 102 may be electrically coupled to the output node AC1. One or more semiconductor bodies forming the third freewheeling element D3 may be arranged on the second section 112₂. One or more semiconductor bodies forming the fourth controllable semiconductor element T4 are arranged on a third section 112₃ of the metallization layer of the first substrate 102. Each of the one or more semiconductor bodies forming the fourth controllable semiconductor element T4 may be electrically coupled to the third section 112₃ by means of an electrically conductive connection layer. The third section 112₃ may be electrically coupled to the first midpoint node M1. Each of the one or more semiconductor bodies forming the third freewheeling element D3, and each of the one or more semiconductor bodies forming the fourth controllable semiconductor element T4 may be electrically coupled to a fourth section 112₄ of the metallization layer of the first substrate 102 by means of one or more electrical connections (e.g., bonding wires or ribbons).

One or more semiconductor bodies forming the second controllable semiconductor element T2 and one or more semiconductor bodies forming the second freewheeling element D2 may be arranged on a first section 114i of the metallization layer of the second substrate 104. Each of the one or more semiconductor bodies forming the second controllable semiconductor element T2 and each of the one or more semiconductor bodies forming the second freewheeling element D2 may be electrically coupled to the first section 114i by means of an electrically conducting connection layer, for example. Each of the one or more semiconductor bodies forming the second controllable semiconductor element T2 and each of the one or more semiconductor bodies forming the second freewheeling element D2 may be electrically coupled to a second section 114₂ of the metallization layer of the second substrate 104, e.g., by means of one or more electrical connections (e.g., bonding wires or ribbons). The first section 114i may be electrically coupled to the output node AC1, and the second section 114₂ may be electrically coupled to the second supply node N1. One or more semiconductor bodies forming the fourth freewheeling element D4 are arranged on a third section 114₃ of the metallization layer of the second substrate 104. The third section 114₃ may be electrically coupled to the second midpoint node M2. One or more semiconductor bodies forming the third controllable semiconductor element T3 are arranged on and electrically coupled to (e.g., by means of an electrically conducting connection layer ) the first section 114i of the metallization layer of the second substrate 104. Each of the one or more semiconductor bodies forming the third controllable semiconductor element T3, and each of the one or more semiconductor bodies forming the fourth freewheeling element D4 may be electrically coupled to a fourth section 114₄ of the metallization layer of the second substrate 104, e.g., by means of one or more electrical connections (e.g., bonding wires or ribbons).

The second section 112₂ of the metallization layer of the first substrate 102 and the first section 114i of the metallization layer of the second substrate 104 may be electrically coupled to each other, e.g., by means of one or more electrical connections (e.g., bonding wires or ribbons). The fourth section 112₄ of the metallization layer of the first substrate 102 may form the third common node, and the fourth section 114₄ of the metallization layer of the second substrate 104 may form the fourth common node. As has been described above, the third common node and the fourth common node may be electrically connected to each other. Therefore, the fourth section 112₄ of the metallization layer of the first substrate 102 and the fourth section 114₄ of the metallization layer of the second substrate 104 may be electrically coupled to each other, e.g., by means of one or more electrical connections (e.g., bonding wires or ribbons). The one or more electrical connections between the fourth section 112₄ of the metallization layer of the first substrate 102 and the fourth section 114₄ of the metallization layer of the second substrate 104 as well as the one or more electrical connections between the second section 112₂ of the metallization layer of the first substrate 102 and the first section 114i of the metallization layer of the second substrate 104 provide a low inductive connection between the first substrate 102 and the second substrate 104.

According to further embodiments of the disclosure, a protection diode may be arranged anti-parallel to the third controllable semiconductor element T3, and a further protection diode may be arranged anti-parallel to the fourth controllable semiconductor element T4. The voltage class of such protection diode may be chosen to be the same or higher than the voltage class of the third and fourth controllable semiconductor element T3, T4, respectively. A low current rating may be chosen for the protection diodes, as the protection diodes only need to carry a reverse current for a comparably short period during reverse recovery of the third freewheeling element D3 or the fourth freewheeling element D4, respectively.

## Claims

1. A semiconductor arrangement comprising:
a first supply node (P1) configured to be operatively connected to a first electrical potential (DC+), and a second supply node (N1) configured to be operatively connected to a second electrical potential (DC-), the first electrical potential (DC+) being positive with reference to the second electrical potential (DC-);
a first controllable semiconductor element (T1) and a second controllable semiconductor element (T2), each having a control electrode (G1, G2) and a controllable load path between two load electrodes, the load paths being operatively connected in series and between the first supply node (P1) and the second supply node (N1), the first controllable semiconductor element (T1) and the second semiconductor element (T2) being connected with each other via an output node (AC1);
a first and a second freewheeling element (D1, D2), each having a first electrode and a second electrode, the first freewheeling element (D1) being connected in parallel to the first controllable semiconductor element (T1) and between the respective nodes, and the second freewheeling element (D2) being connected in parallel to the second controllable semiconductor elements (T2) and between the respective nodes;
a third freewheeling element (D3) having a first electrode and a second electrode, and a fourth controllable semiconductor element (T4) having a control electrode (G4) and a controllable load path between two load electrodes, the third freewheeling element (D3) and the load path of the fourth controllable semiconductor element (T4) being operatively coupled in series and between the output node (AC1) and a first midpoint node (M1); and
a third controllable semiconductor element (T3) having a control electrode (G3) and a controllable load path between two load electrodes, and a fourth freewheeling element (D4) having a first electrode and a second electrode, the load path of the third controllable semiconductor element (T3) and the fourth freewheeling element (D4) being operatively connected in series and between the output node (AC1) and a second midpoint node (M2) that is different from the first midpoint node (M1).

2. The semiconductor arrangement of claim 1, wherein one of,
a second load electrode of the fourth controllable semiconductor element (T4) and the first electrode of the third freewheeling element D3 are connected with each other via a third common node, the fourth controllable semiconductor element (T4) is connected to the first midpoint node (M1) with a first load electrode, the third freewheeling element (D3) is connected to the output node (AC1) with its second electrode, a second load electrode of the third controllable semiconductor element (T3) and the first electrode of the fourth freewheeling element (D4) are connected with each other via a fourth common node, the third controllable semiconductor element T3 is connected to the output node (AC1) with a first load electrode, and the fourth freewheeling element (D4) is connected to the second midpoint node (M2) with its second electrode, or
the first load electrode of the fourth controllable semiconductor element (T4) and the second electrode of the third freewheeling element D3 are connected with each other via the third common node, the fourth controllable semiconductor element (T4) is connected to the first midpoint node (M1) with its second load electrode, the third freewheeling element (D3) is connected to the output node (AC1) with its first electrode, the first load electrode of the third controllable semiconductor element (T3) and the second electrode of the fourth freewheeling element (D4) are connected with each other via the fourth common node, the third controllable semiconductor element T3 is connected to the output node (AC1) with its second load electrode, and the fourth freewheeling element (D4) is connected to the second midpoint node (M2) with its first electrode.

3. The semiconductor arrangement of claim 2, wherein the third common node and the fourth common node are electrically coupled to each other.

4. The semiconductor arrangement of any of claims 1 to 3, wherein,
for positive power factors cos ϕ, the first controllable semiconductor element (T1), the first freewheeling element (D1), the third freewheeling element (D3), and the fourth controllable semiconductor element (T4) form a first main commutation loop, and the second controllable semiconductor element (T2), the second freewheeling element (D2), the third controllable semiconductor element (T3), and the fourth freewheeling element (D4) form a second main commutation loop; and
for negative power factors cos ϕ, the first controllable semiconductor element (T1), the first freewheeling element (D1), the fourth freewheeling element (D4), and the third controllable semiconductor element (T3) form a third main commutation loop, and the second controllable semiconductor element (T2), the second freewheeling element (D2), the fourth controllable semiconductor element (T4), and the third freewheeling element (D3) form a fourth main commutation loop.

5. A power semiconductor module arrangement comprising a first substrate (102) and a second substrate (104), and a plurality of semiconductor bodies forming the semiconductor arrangement according to any of claims 1 to 4, wherein one of
a plurality of semiconductors forming the first main commutation loop is arranged on the first substrate (102), and a plurality of semiconductor bodies forming the second main commutation loop is arranged on the second substrate (104); or
a plurality of semiconductor bodies forming the third main commutation loop is arranged on the first substrate (102), and a plurality of semiconductor bodies forming the fourth main commutation loop is arranged on the second substrate (104).

6. The power semiconductor module arrangement of claim 5, wherein
the plurality of semiconductors forming the first main commutation loop is arranged on the first substrate (102), and the plurality of semiconductor bodies forming the second main commutation loop is arranged on the second substrate (104), and,
for positive power factors cos φ, at any time a current only flows on the first substrate (102) or on the second substrate (104) but not on both.

7. The power semiconductor module arrangement of claim 5 or 6, wherein
the first substrate (102) comprises a dielectric insulation layer and a metallization layer arranged on the dielectric insulation layer, wherein the metallization layer comprises a plurality of different separate sections (112₁, 112₂, 112₃, 112₄); and
the second substrate (104) comprises a dielectric insulation layer and a metallization layer arranged on the dielectric insulation layer, wherein the metallization layer comprises a plurality of different separate sections (114₁, 114₂, 114₃, 114₄).

8. The power semiconductor module arrangement of claim 7, wherein
a plurality of semiconductors forming the first main commutation loop is arranged on the first substrate (102), and a plurality of semiconductor bodies forming the second main commutation loop is arranged on the second substrate (104);
a first section (112i) of the metallization layer of the first substrate (102) is electrically coupled to the first supply node P1;
one or more semiconductor bodies forming the first controllable semiconductor element (T1), and one or more semiconductor bodies forming the first freewheeling element (D1) are arranged on and electrically coupled to the first section (112i);
each of the one or more semiconductor bodies forming the first controllable semiconductor element (T1), and each of the one or more semiconductor bodies forming the first freewheeling element (D1) is electrically coupled to a second section (112₂) of the metallization layer of the first substrate (102), wherein the second section (112₂) is electrically coupled to the output node (AC1);
one or more semiconductor bodies forming the third freewheeling element (D3) are arranged on the second section (112₂);
one or more semiconductor bodies forming the fourth controllable semiconductor element (T4) are arranged on and electrically coupled to a third section (112₃) of the metallization layer of the first substrate (102);
the third section (112₃) is electrically coupled to the first midpoint node (M1); each of the one or more semiconductor bodies forming the third freewheeling element (D3), and each of the one or more semiconductor bodies forming the fourth controllable semiconductor element (T4) is electrically coupled to a fourth section (112₄) of the metallization layer of the first substrate (102).

9. The power semiconductor module arrangement of claim 7 or 8, wherein
a plurality of semiconductors forming the first main commutation loop is arranged on the first substrate (102), and a plurality of semiconductor bodies forming the second main commutation loop is arranged on the second substrate (104);
one or more semiconductor bodies forming the third controllable semiconductor element (T3), one or more semiconductor bodies forming the second controllable semiconductor element (T2), and one or more semiconductor bodies forming the second freewheeling element (D2) are arranged on and electrically coupled to a first section (114₁) of the metallization layer of the second substrate (104);
each of the one or more semiconductor bodies forming the second controllable semiconductor element (T2) and each of the one or more semiconductor bodies forming the second freewheeling element (D2) is electrically coupled to a second section (114₂) of the metallization layer of the second substrate (104);
the first section (114₁) is electrically coupled to the output node (AC1), and the second section (114₂) is electrically coupled to the second supply node (N1);
one or more semiconductor bodies forming the fourth freewheeling element (D4) are arranged on and electrically coupled to a third section (114₃) of the metallization layer of the second substrate (104), wherein the third section (114₃) is electrically coupled to the second midpoint node (M2);
each of the one or more semiconductor bodies forming the third controllable semiconductor element (T3), and each of the one or more semiconductor bodies forming the fourth freewheeling element (D4) is electrically coupled to a fourth section (114₄) of the metallization layer of the second substrate (104).

10. The power semiconductor module arrangement of claim 9, wherein at least one of
the second section (112₂) of the metallization layer of the first substrate (102) and the first section (114₁) of the metallization layer of the second substrate (104) are electrically coupled to each other, and
the fourth section (112₄) of the metallization layer of the first substrate (102) and the fourth section (114₄) of the metallization layer of the second substrate (104) are electrically coupled to each other.

11. The power semiconductor module arrangement of any of claims 5 to 10, wherein
the semiconductor bodies arranged on the first substrate (102) comprise a first subgroup and a second subgroup, wherein the first subgroup comprises fast switching semiconductor elements, and the second subgroup comprises slow switching semiconductor elements; and
the semiconductor bodies arranged on the second substrate (104) comprise a third subgroup and a fourth subgroup, wherein the third subgroup comprises fast switching semiconductor elements, and the fourth subgroup comprises slow switching semiconductor elements.

12. The power semiconductor module arrangement of claim 11, wherein
the semiconductor bodies included in the first subgroup are arranged together as a first group of elements (41) in a first section of the first substrate (102);
the semiconductor bodies included in the second subgroup are arranged together as a second group of elements (42) in a second section of the first substrate (102);
the semiconductor bodies included in the third subgroup are arranged together as a third group of elements (43) in a first section of the second substrate (104); and
the semiconductor bodies included in the fourth subgroup are arranged together as a fourth group of elements (44) in a second section of the second substrate (104).

13. The power semiconductor module arrangement of claim 11 or 12, wherein
a plurality of semiconductors forming the first main commutation loop is arranged on the first substrate (102), and a plurality of semiconductor bodies forming the second main commutation loop is arranged on the second substrate (104);
the first subgroup comprises the one or more semiconductor bodies forming the first controllable semiconductor element (T1);
the second subgroup comprises the one or more semiconductor bodies forming the fourth controllable semiconductor element (T4);
the third subgroup comprises the one or more semiconductor bodies forming the second controllable semiconductor element (T2); and
the fourth subgroup comprises the one or more semiconductor bodies forming the third controllable semiconductor element (T3).

14. The power semiconductor module arrangement of any of claims 11 to 13, wherein a fast switching semiconductor element is a semiconductor element that switches faster than a defined threshold speed, and a slow switching semiconductor element is a semiconductor element that switches slower than the defined threshold speed.

## Amended claims

### Amended claims in accordance with Rule 137(2) EPC.

1. A power semiconductor module arrangement comprising a first substrate (102) and a second substrate (104), and a plurality of semiconductor bodies forming a semiconductor arrangement, the semiconductor arrangement comprising
a first supply node (P1) configured to be operatively connected to a first electrical potential (DC+), and a second supply node (N1) configured to be operatively connected to a second electrical potential (DC-), the first electrical potential (DC+) being positive with reference to the second electrical potential (DC-);
a first controllable semiconductor element (T1) and a second controllable semiconductor element (T2), each having a control electrode (G1, G2) and a controllable load path between two load electrodes, the load paths being operatively connected in series and between the first supply node (P1) and the second supply node (N1), the first controllable semiconductor element (T1) and the second semiconductor element (T2) being connected with each other via an output node (AC1);
a first and a second freewheeling element (D1, D2), each having a first electrode and a second electrode, the first freewheeling element (D1) being connected in parallel to the first controllable semiconductor element (T1) and between the respective nodes, and the second freewheeling element (D2) being connected in parallel to the second controllable semiconductor elements (T2) and between the respective nodes;
a third freewheeling element (D3) having a first electrode and a second electrode, and a fourth controllable semiconductor element (T4) having a control electrode (G4) and a controllable load path between two load electrodes, the third freewheeling element (D3) and the load path of the fourth controllable semiconductor element (T4) being operatively coupled in series and between the output node (AC1) and a first midpoint node (M1); and
a third controllable semiconductor element (T3) having a control electrode (G3) and a controllable load path between two load electrodes, and a fourth freewheeling element (D4) having a first electrode and a second electrode, the load path of the third controllable semiconductor element (T3) and the fourth freewheeling element (D4) being operatively connected in series and between the output node (AC1) and a second midpoint node (M2) that is different from the first midpoint node (M1),
wherein one of
a plurality of semiconductors forming a first main commutation loop is arranged on the first substrate (102), and a plurality of semiconductor bodies forming a second main commutation loop is arranged on the second substrate (104); or
a plurality of semiconductor bodies forming a third main commutation loop is arranged on the first substrate (102), and a plurality of semiconductor bodies forming a fourth main commutation loop is arranged on the second substrate (104), and wherein
the semiconductor bodies arranged on the first substrate (102) comprise a first subgroup and a second subgroup, wherein the first subgroup comprises fast switching semiconductor elements, and the second subgroup comprises slow switching semiconductor elements;
the semiconductor bodies arranged on the second substrate (104) comprise a third subgroup and a fourth subgroup, wherein the third subgroup comprises fast switching semiconductor elements, and the fourth subgroup comprises slow switching semiconductor elements;
the semiconductor bodies included in the first subgroup are arranged together as a first group of elements (41) in a first section of the first substrate (102);
the semiconductor bodies included in the second subgroup are arranged together as a second group of elements (42) in a second section of the first substrate (102);
the semiconductor bodies included in the third subgroup are arranged together as a third group of elements (43) in a first section of the second substrate (104); and
the semiconductor bodies included in the fourth subgroup are arranged together as a fourth group of elements (44) in a second section of the second substrate (104).

2. The power semiconductor module arrangement of claim 1, wherein one of,
a second load electrode of the fourth controllable semiconductor element (T4) and the first electrode of the third freewheeling element D3 are connected with each other via a third common node, the fourth controllable semiconductor element (T4) is connected to the first midpoint node (M1) with a first load electrode, the third freewheeling element (D3) is connected to the output node (AC1) with its second electrode, a second load electrode of the third controllable semiconductor element (T3) and the first electrode of the fourth freewheeling element (D4) are connected with each other via a fourth common node, the third controllable semiconductor element T3 is connected to the output node (AC1) with a first load electrode, and the fourth freewheeling element (D4) is connected to the second midpoint node (M2) with its second electrode, or
the first load electrode of the fourth controllable semiconductor element (T4) and the second electrode of the third freewheeling element D3 are connected with each other via the third common node, the fourth controllable semiconductor element (T4) is connected to the first midpoint node (M1) with its second load electrode, the third freewheeling element (D3) is connected to the output node (AC1) with its first electrode, the first load electrode of the third controllable semiconductor element (T3) and the second electrode of the fourth freewheeling element (D4) are connected with each other via the fourth common node, the third controllable semiconductor element T3 is connected to the output node (AC1) with its second load electrode, and the fourth freewheeling element (D4) is connected to the second midpoint node (M2) with its first electrode.

3. The power semiconductor module arrangement of claim 2, wherein the third common node and the fourth common node are electrically coupled to each other.

4. The power semiconductor module arrangement of any of claims 1 to 3, wherein,
for positive power factors cos ϕ, the first controllable semiconductor element (T1), the first freewheeling element (D1), the third freewheeling element (D3), and the fourth controllable semiconductor element (T4) form a first main commutation loop, and the second controllable semiconductor element (T2), the second freewheeling element (D2), the third controllable semiconductor element (T3), and the fourth freewheeling element (D4) form a second main commutation loop; and
for negative power factors cos ϕ, the first controllable semiconductor element (T1), the first freewheeling element (D1), the fourth freewheeling element (D4), and the third controllable semiconductor element (T3) form a third main commutation loop, and the second controllable semiconductor element (T2), the second freewheeling element (D2), the fourth controllable semiconductor element (T4), and the third freewheeling element (D3) form a fourth main commutation loop.

5. The power semiconductor module arrangement of any of claims 1 to 4, wherein
the plurality of semiconductors forming the first main commutation loop is arranged on the first substrate (102), and the plurality of semiconductor bodies forming the second main commutation loop is arranged on the second substrate (104), and,
for positive power factors cos φ, at any time a current only flows on the first substrate (102) or on the second substrate (104) but not on both.

6. The power semiconductor module arrangement of any of the preceding claims, wherein
the first substrate (102) comprises a dielectric insulation layer and a metallization layer arranged on the dielectric insulation layer, wherein the metallization layer comprises a plurality of different separate sections (112₁, 112₂, 112₃, 112₄); and
the second substrate (104) comprises a dielectric insulation layer and a metallization layer arranged on the dielectric insulation layer, wherein the metallization layer comprises a plurality of different separate sections (114₁, 114₂, 114₃, 114₄).

7. The power semiconductor module arrangement of claim 6, wherein
a plurality of semiconductors forming the first main commutation loop is arranged on the first substrate (102), and a plurality of semiconductor bodies forming the second main commutation loop is arranged on the second substrate (104);
a first section (112₁) of the metallization layer of the first substrate (102) is electrically coupled to the first supply node P1;
one or more semiconductor bodies forming the first controllable semiconductor element (T1), and one or more semiconductor bodies forming the first freewheeling element (D1) are arranged on and electrically coupled to the first section (112₁);
each of the one or more semiconductor bodies forming the first controllable semiconductor element (T1), and each of the one or more semiconductor bodies forming the first freewheeling element (D1) is electrically coupled to a second section (112₂) of the metallization layer of the first substrate (102), wherein the second section (112₂) is electrically coupled to the output node (AC1);
one or more semiconductor bodies forming the third freewheeling element (D3) are arranged on the second section (112₂);
one or more semiconductor bodies forming the fourth controllable semiconductor element (T4) are arranged on and electrically coupled to a third section (112₃) of the metallization layer of the first substrate (102);
the third section (112₃) is electrically coupled to the first midpoint node (M1);
each of the one or more semiconductor bodies forming the third freewheeling element (D3), and each of the one or more semiconductor bodies forming the fourth controllable semiconductor element (T4) is electrically coupled to a fourth section (112₄) of the metallization layer of the first substrate (102).

8. The power semiconductor module arrangement of claim 6 or 7, wherein
a plurality of semiconductors forming the first main commutation loop is arranged on the first substrate (102), and a plurality of semiconductor bodies forming the second main commutation loop is arranged on the second substrate (104);
one or more semiconductor bodies forming the third controllable semiconductor element (T3), one or more semiconductor bodies forming the second controllable semiconductor element (T2), and one or more semiconductor bodies forming the second freewheeling element (D2) are arranged on and electrically coupled to a first section (114₁) of the metallization layer of the second substrate (104);
each of the one or more semiconductor bodies forming the second controllable semiconductor element (T2) and each of the one or more semiconductor bodies forming the second freewheeling element (D2) is electrically coupled to a second section (114₂) of the metallization layer of the second substrate (104);
the first section (114₁) is electrically coupled to the output node (AC1), and the second section (114₂) is electrically coupled to the second supply node (N1);
one or more semiconductor bodies forming the fourth freewheeling element (D4) are arranged on and electrically coupled to a third section (114₃) of the metallization layer of the second substrate (104), wherein the third section (114₃) is electrically coupled to the second midpoint node (M2);
each of the one or more semiconductor bodies forming the third controllable semiconductor element (T3), and each of the one or more semiconductor bodies forming the fourth freewheeling element (D4) is electrically coupled to a fourth section (114₄) of the metallization layer of the second substrate (104).

9. The power semiconductor module arrangement of claim 8, wherein at least one of
the second section (112₂) of the metallization layer of the first substrate (102) and the first section (114₁) of the metallization layer of the second substrate (104) are electrically coupled to each other, and
the fourth section (112₄) of the metallization layer of the first substrate (102) and the fourth section (114₄) of the metallization layer of the second substrate (104) are electrically coupled to each other.

10. The power semiconductor module arrangement of any of the preceding claims, wherein
a plurality of semiconductors forming the first main commutation loop is arranged on the first substrate (102), and a plurality of semiconductor bodies forming the second main commutation loop is arranged on the second substrate (104);
the first subgroup comprises the one or more semiconductor bodies forming the first controllable semiconductor element (T1);
the second subgroup comprises the one or more semiconductor bodies forming the fourth controllable semiconductor element (T4);
the third subgroup comprises the one or more semiconductor bodies forming the second controllable semiconductor element (T2); and
the fourth subgroup comprises the one or more semiconductor bodies forming the third controllable semiconductor element (T3).

11. The power semiconductor module arrangement of any of the preceding claims, wherein a fast switching semiconductor element is a semiconductor element that switches faster than a defined threshold speed, and a slow switching semiconductor element is a semiconductor element that switches slower than the defined threshold speed.
